# EUROPEAN PATENT SPECIFICATION

(11) **EP 0 605 689 B1**
(45) Date of publication and mention of the grant of the patent: **15.05.1996**
(21) Application number: 93914917.5
(22) Date of filing: 12.07.1993
(51) Int. Cl.: H01R 4/04, H01R 23/72, H01B 1/22, H01B 1/24, H01B 1/20

(54) **ANISOTROPIC ELECTRICAL CONNECTION**
ANISOTROPISCHE ELEKTRISCHE VERBINDUNG
CONNEXION ELECTRIQUE ANISOTROPE

(30) Priority: 18.07.1992 GB 9215328
(43) Date of publication of application: 13.07.1994
(73) Proprietor: CENTRAL RESEARCH LABORATORIES LIMITED, Hayes, Middlesex, UB3 1HH (GB)
(72) Inventor: NAYLOR, Malcolm, Hayes, Middlesex UB3 1HH (GB)
(74) Representative: Osborne, David Ernest
(86) International application number: GB9301448
(87) International publication number: WO9402974

(56) References cited:
- EP-A- 0 428 165
- FR-A- 2 549 627
- GB-A- 2 131 814
- US-A- 4 814 040
- US-A- 5 001 302
- Patent Abstracts of Japan vol.10, no.280(C-374)24 Sept.1986 & JP-A- 61 098 781 (NIPPON DEMPA KOGYO CO LTD) 17 May 1986

## Description

This invention relates to anisotropic electrical connection, and in particular to an adhesive for the anisotropic electrical connection of electrically conductive elements.

More specifically, the invention relates to the electrical interconnection of aligned conductive elements mounted respectively on first and second substrates, without electrical interconnection between adjacent conductors on each substrate.

This is a common requirement, for example, in the production of LCDs or other display panels. In this case, one substrate may be the glass display panel, the electrically conductive elements mounted thereon commonly being formed of a transparent oxide of indium and tin (ITO). The required interconnection is that of the ITO elements to a circuit board for supplying the required driving voltages.

One well established technique for achieving this interconnection is the use of a substrate of thin flexible material in the form of a strip carrying tracks of metal or conductive ink. The strip is bonded to the glass substrate at one end, and to the circuit board at the other end. Alternatively, the circuit board may be incorporated on the strip. Electrical interconnection is achieved by the use of an adhesive substance which forms an anisotropic connection in bonding. The substance comprises an adhesive polymer in which metallic particles are suspended.

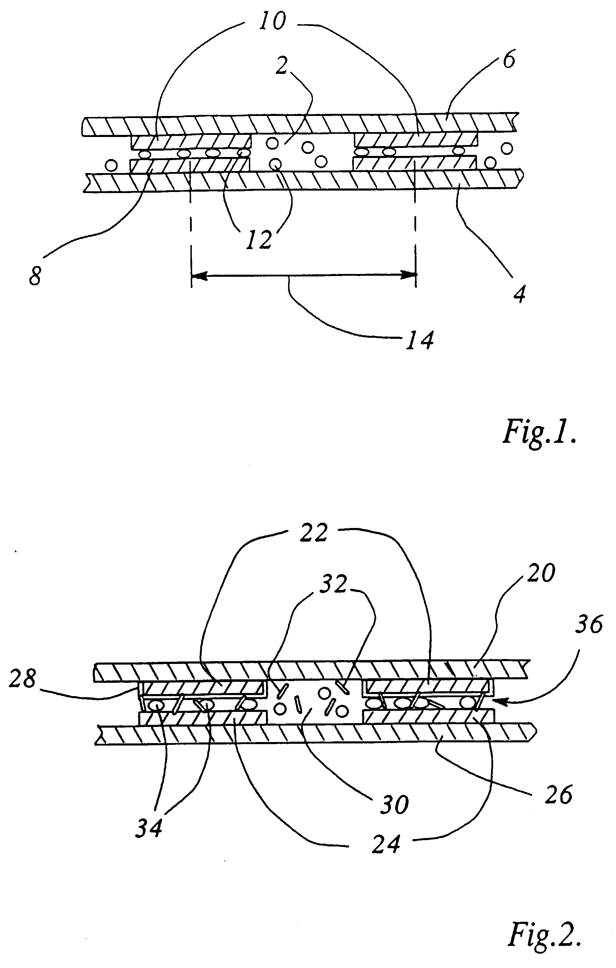

This known method of connecting ITO conductors is shown diagrammatically in Figure 1 of the accompanying drawings. The adhesive 2 is sandwiched between the end of the flexible strip 4 and the edge of the glass display panel 6, with the conductive elements 8,10 aligned. Heat and pressure are applied to the joint, such that the metallic particles 12 deform between the aligned conductors 8,10 on the panel 6 and the flexible substrate 4 forming an electrically conductive pathway therebetween. The adhesive is then cured or set by heat to maintain the conductive pathways. Since the metallic particles 12, are small compared to the gap between the conductive elements 8,10 on each substrate 4,6 electrical connection is not made between adjacent conductors 8 or 10.

With the fast rate of addressing which is possible with FLCD (ferro-electric liquid crystal display) technology, it is preferable to use low resistive conductive elements or electrodes on the display substrate. This can be achieved by adding a much narrower metal conductor to each ITO element to increase its conductivity, or by replacing the ITO elements with metallic elements where transparency is not required, for example in printer applications or outside of the active display area.

Aluminium is suitable for this purpose due to its high electrical conductivity. However, connection of aluminium conductors using the method described above has been found to be unreliable. This appears to be due to the non-conductive oxide which forms on the surface of aluminium, the metallic particles merely being squashed when the substrates are pressed together in bonding thus distributing the load over a larger area, and not being capable of fracturing the oxide layer in order to make reliable electrical contact with the conductor.

It is an object of this invention to mitigate this problem.

From one aspect the present invention consists in a method of forming an anisotropic electrical connection between first and second substrates each having a plurality of adjacent conductive elements mounted thereon, at least some of the conductive elements having a non-conductive coating, the method comprising the steps of: aligning the substrates such that at least some of the conductive elements on the first substrate overlie a respective conductive element on the second substrate, and sandwiching between the substrates a substance comprising an insulating adhesive and a plurality of electrically conductive particles, some of the particles being capable of penetrating the conductive elements having a non-conductive coating by piercing the coating, and some of the particles being capable of deforming between the overlying elements, on the application of pressure between the substrates, and applying pressure between the substrates such that the substance forms an electrical connection between the overlying elements whilst isolating the adjacent elements from each other.

From another aspect the invention consists in an electrically interconnected assembly comprising first and second substrates each having a plurality of adjacent conductive elements mounted thereon, at least some of the conductive elements having a non-conductive coating, and being aligned such that at least some of the conductive elements on the first substrate each overlie a respective conductive element on the second substrate, and a substance including an adhesive bonding the substrates together, the substance forming an electrical connection between the overlying elements whilst isolating the adjacent elements from each other, and the substance including electrically conductive particles, some of which have pierced the non-conductive coating and penetrated the conductive element and some of which have deformed between the overlying elements.

The elements having a non-conductive coating may be of a metal which forms a stable oxide, for example, aluminium. Particles capable of piercing aluminium oxide have been found to include carbon fibres, disilicides, titanium diboride and tungsten whiskers.

The deformable particles may be metallic; for example, gold plated nickel. The adhesive base is conveniently a polymer base, or may be, for example, of chemically bonded ceramics such as magnesium-aluminium phosphates.

Various techniques involving the use of an adhesive matrix containing electrically conductive (and sometimes also electrically insulative) particles have been proposed for selectively interconnecting conductive elements of respective arrays or for generally making electrical connection and physical attachment between conductors and electrical/electronic devices. In particular, Patents Abstrats of Japan vol 10, no. 280 (C374) and JP, A, 61 098 781 discloses a conductive adhesive, comprising conductive particles in an adhesive matrix, used for connecting conductors to electrical/electronic devices. The adhesive is given greater mechanical strength by the addition of fibrous or filimentary material to the matrix. GB,A,2 131 814 discloses a film-like adhesive which contains conductive fibrils which are caused to lie substantially parallel to the film surfaces. US,A,5 001 302 discloses an anisotropic connecting structure including a hot melt adhesive, heat resilient particles comprising metal-plated thermoplastic resin, and carbon particles, which latter particles melt when the structure is placed under thermal compression to aid adhesion as well as conduction between terminals. US,A,4 814 040 describes an adhesive used for establishing connection to a conductive pattern, superimposed upon which is a conductive resist layer. The adhesive contains metallic particles the dimensions of which exceed the thickness of the resist layer so that, upon thermal compression, the particles can penetrate the resist layer. EP,A,0 428 165 discloses agglomerate particles in a cement which is designed to shrink, providing compaction and thus improved contact. FR,A, 2 549 627 discloses an adhesive containing a mixture of conductive and non-conductive micro-particles.

The invention will now be described, by way of example, with reference to the accompanying diagrammatic drawings, which are not to scale, and in which:
Figure 1 is a cross-sectional view of an assembly according to the prior art, as already referred to above; and
Figure 2 is a cross-sectional view of an assembly according to the invention.

Referring to Figure 2, it is required to connect first aluminium conductive elements 22 at the edge of a first substrate, which forms a glass display panel 20 of an FLCD screen, to a circuit board for supplying driving voltages. This is achieved by joining the elements 22 to second conductive elements 24, for example, of copper, gold-plated copper, silver or carbon-loaded inks, which are carried by a second substrate 26 in the form of a flexible strip. It is necessary to connect each first element 22 to a respective overlying second element 24 without connecting the adjacent first elements 22 together, or connecting the adjacent second elements 24 together.

An anisotropically electrically conductive adhesive substance 30, which conveniently is supplied in the form of a film, is sandwiched between the substrate 20,26, and heat and pressure are applied to the joint.

Referring to Figure 2, the adhesive substance 30, which may comprise a polymer base, includes carbon fibres 32, and metallic particles 34, such as gold coated nickel particles.

The aluminium elements 22 on the first substrate 20 have a non-conductive oxide coating 28. When the joint is made, the carbon fibres which are captured in the gaps 36 between respective overlying conductors 22,24 pierce the oxide coating 28 and penetrate the bodies of the aluminium elements 22. The metallic particles, however, are squashed between the elements 22,24.

The particles 32,34 are in sufficient quantity that an electrical connection is made between overlying conductors 22,24, but no such connection is made between adjacent conductors 22 or 24. For instance, in the gap 36 between overlying conductors 22,24 some carbon fibres 32 may penetrate the oxide layers 28 of the first element 22, and also contact the second element 24. Alternatively some fibres 32 which penetrate a first element 22 may contact a metallic particle 34, which contacts the second element 24.

With conductive elements having a pitch of about lmm, and a depth of about 0.0002mm, carbon fibres having an average length of about 0.05mm have been found to be suitable; for example, fibres supplied by Courtaulds Grafil Limited as 'Grafil HM-S/0.50 un-sized carbon fibres'.

Whilst one embodiment of the invention has been described, it will be appreciated that modifications may be made without departing from the scope of the invention. For example, the conductive elements may be formed of another material having a stable oxide coating.

## Claims

1. A method of forming an anisotropic electrical connection between first (20) and second (26) substrates each having a plurality of adjacent conductive elements (22,24) mounted thereon, at least some of the conductive elements (22) having a non-conductive coating (28), the method comprising the steps of: aligning the substrates (20,26) such that at least some of the conductive elements (22) on the first substrate (20) overlie a respective conductive element (24) on the second substrate (26), and sandwiching between the substrates a substance (30) including an insulating adhesive and a plurality of electrically conductive particles (32, 34), some of the particles (34) being capable of deforming between the overlying elements (22,24) on the application of pressure between the substrates (20,26) and characterised by some of the particles (32) being capable of penetrating the conductive elements (22) having a non-conductive coating (28) by piercing the coating on the application of pressure between the substrates (20,26), and applying pressure between the substrates such that the substance (30) forms an elecrical connection between the overlying elements (22, 24) whilst isolating the adjacent elements (22,22 or 24,24) from each other.

2. A method as claimed in claim 1, in which the elements (22) having a non-conductive coating (28) are of a metal which forms a stable oxide coating.

3. A method as claimed in claim 1 or 2, in which the particles (32) capable of piercing the non-conductive coating are fibrous particles.

4. A method as claimed in claim 1, 2 or 3, in which the particles (32) capable of piercing the non-conductive coating are non-metallic.

5. A method as claimed in any preceding claim, in which the particles (32)capable of piercing the non-conductive coating are carbon fibres.

6. A method as claimed in any preceding claim in which the conductive particles (34) which deform when pressure is applied between the substrates (20, 26) are metallic.

7. An electrically interconnected assembly comprising first and second substrates (20, 26) each having a plurality of adjacent conductive elements (22, 24) mounted thereon, at least some of the conductive elements (22) having a non-conductive coating (28), and being aligned such that at least some of the conductive elements (22) on the first substrate (20) each overlie a respective conductive element (24) on the second substrate (26), and a substance (30) including adhesive bonding the substrates together, the substance forming an electrical connection between the overlying elements (22, 24) whilst isolating the adjacent elements (22 or 24) from each other, and characterised by the substance including electrically conductive particles (32, 34) some of which (32) have pierced the non-conductive coating (28) and penetrated the conductive element (22), and some of which (34) have deformed between the overlying elements (22, 24).

## Patentansprüche

1. Verfahren zur Bildung einer anisotropen elektrischen Verbindung zwischen einem ersten (20) und einem zweiten (22) Substrat, wobei jedes Substrat eine Vielzahl von auf ihm angebrachten benachbarten leitenden Elementen (22, 24) aufweist, von denen wenigstens einige (22) eine nicht-leitende Beschichtung (28) haben, umfassend die Schritte: Ausrichten der Substrate (20, 26) so, daß wenigstens einige der leitenden Elemente (22) auf dem ersten Substrat (20) über einem entsprechenden leitenden Element (24) auf dem zweiten Substrat liegen, sandwichartiges Anordnen einer Substanz (30) zwischen den Substraten, die einen isolierenden Kleber und eine Vielzahl von elektrisch leitenden Partikeln (32, 34) enthält, wobei einige der Partikel (34) in der Lage sind, sich zwischen den übereinanderliegenden Elementen (22, 24) bei Ausübung eines Druckes zwischen den Substraten (20, 26) zu verformen, gekennzeichnet dadurch, daß einige Partikel (32) in der Lage sind, die leitenden Elemente (22), die eine nicht-leitende Beschichtung (28) haben, durch Durchstoßung der Schicht bei Ausübung von Druck zwischen den Substraten (20, 26) zu durchdringen, und daß Druck zwischen den Substraten ausgeübt wird, so daß die Substanz (30) eine elektrische Verbindung zwischen den übereinanderliegenden Elementen (22, 24) bildet, während die benachbarten Elemente (22, 22 oder 24, 24) voneinander isoliert sind.

2. Verfahren nach Anspruch 1, bei dem die Elemente (22), die eine nicht-leitende Beschichtung (28) haben, aus einem Metall bestehen, das eine stabile Oxidschicht bildet.

3. Verfahren nach Anspruch 1 oder 2, bei dem die Partikel (32), die in der Lage sind, die nicht-leitende Beschichtung zu durchstoßen, Faserpartikel sind.

4. Verfahren nach Anspruch 1, 2 oder 3, bei dem die Partikel (32), die in der Lage sind, die nicht-leitende Beschichtung zu durchstoßen, nicht metallisch sind.

5. Verfahren nach einem der vorhergehenden Ansprüche, bei dem die Partikel, die in der Lage sind, die nicht-leitende Beschichtung zu durchstoßen, Kohlenstoff-Fasern sind.

6. Verfahren nach einem der vorhergehenden Ansprüche, bei dem die leitenden Partikel (34), die sich deformieren, wenn Druck zwischen den Substraten (20, 26) ausgeübt wird, metallisch sind.

7. Elektrisch untereinander verbundene Anordnung, umfassend: ein erstes (20) und ein zweites (26) Substrat, wobei jedes Substrat eine Vielzahl von auf ihm angebrachten benachbarten leitenden Elementen (22, 24) aufweist, von denen wenigstens einige (22) eine nicht-leitende Beschichtung (28) haben, und die so ausgerichtet sind, daß wenigstens einige der leitenden Elemente (22) auf dem ersten Substrat (20) jeweils über einem entsprechenden leitenden Element (24) auf dem zweiten Substrat liegen; und eine Substanz (30), die einen die Substrate verbindenden Kleber enthält, wobei die Substanz eine elektrische Verbindung zwischen den übereinanderliegenden Elementen (22, 24) bildet, während sie benachbarten Elemente (22) oder (24) voneinander isoliert, und gekennzeichnet dadurch, daß die Substanz elektrisch leitende Partikel (32, 34) enthält, von denen einige (32) die nicht-leitende Beschichtung (28) durchstoßen und das leitende Element (22) durchdrungen haben und einige (34) sich zwischen den übereinanderliegenden Elementen (22, 24) verformt haben.

## Revendications

1. Un procédé de formation d'une connexion électrique anisotrope entre un premier (20) et un deuxième (26) substrats sur chacun desquels est montée une série d'éléments conducteurs adjacents (22, 24), au moins certains des éléments conducteurs (22) étant pourvus d'un revêtement non conducteur (28), le procédé comprenant les étapes consistant à: aligner les substrats (26) d'une manière telle qu'au moins certains des éléments conducteurs (22) du premier substrat (20) sont superposés à un élément conducteur respectif (24) du deuxième substrat et prendre en sandwich entre les substrats une substance (30) qui inclut un adhésif isolant et une série de particules électriquement conductrices (32, 34), certaines des particules (34) étant susceptibles de se déformer entre les éléments superposés (22, 24) lors de l'application d'une pression entre les substrats (20, 26) et caractérisé en ce que certaines des particules (32) sont susceptibles de pénétrer dans les éléments conducteurs (22) à revêtement non conducteur (28) en perçant le revêtement lors de l'application d'une pression entre les substrats (20, 26), et qu'une pression est appliquée entre les substrats d'une manière telle que la substance (30) forme une connexion électrique entre les éléments superposés (22, 24) tout en isolant les uns des autres les éléments adjacents (22, 22 ou 24, 24).

2. Un procédé selon la revendication 1, dans lequel les éléments (22) à revêtement non conducteur (28) sont en un métal qui forme un revêtement d'oxyde stable.

3. Un procédé selon la revendication 1 ou 2, dans lequel les particules (32) susceptibles de percer le revêtement non conducteur sont des particules fibreuses.

4. Un procédé selon la revendication 1, 2 ou 3, dans lequel les particules (32) susceptibles de percer le revêtement non conducteur sont non métalliques.

5. Un procédé selon une revendication précédente quelconque, dans lequel les particules (32) susceptibles de percer le revêtement non conducteur sont des fibres de carbone.

6. Un procédé selon une revendication précédente quelconque dans lequel les particules conductrices (34) qui se déforment lorsqu'une pression est appliquée entre les substrats (20, 26) sont métalliques.

7. Un ensemble électriquement interconnecté comprenant un premier et un deuxième substrats (20, 26) sur chacun desquels est montée une série d'éléments conducteurs adjacents (22, 24), au moins certains des éléments conducteurs (22) étant pourvus d'un revêtement non conducteur (28), et qui sont allignés d'une manière telle qu'au moins certains des éléments conducteurs (22) du premier substrat (20) sont superposés chacun à un élément conducteur respectif (24) du deuxième substrat (26) et une substance (30) qui inclut un adhésif qui attache les substrats entre eux, la substance formant une connexion électrique entre les éléments superposés (22, 24) tout en isolant les uns des autres les éléments adjacents (22, 24), et caractérisé en ce que la substance inclut des particules électriquement conductrices (32, 34) dont certaines (32) ont percé le revêtement non conducteur (28) et ont pénétré dans l'élément conducteur (22) et dont certaines (34) se sont déformées entre les éléments superposés (22, 24).
